# EUROPEAN PATENT APPLICATION

(11) **EP 2 787 535 A2**
(43) Date of publication of application: **08.10.2014**
(21) Application number: 14160368.8
(22) Date of filing: 17.03.2014
(51) Int. Cl.: H01L 31/032

(54) **Solar cell and method of manufacturing the same**

(30) Priority: 01.04.2013 KR 20130035463
(71) Applicant: Samsung SDI Co., Ltd., Yongin-si, Gyeonggi-do (KR)
(72) Inventor: Lee, Cho-Young, Gyeonggi-do (KR); Oh, Min-Seok, Gyeonggi-do (KR); Lee, Yun-Seok, Gyeonggi-do (KR); Hong, Jun-Ki, Gyeonggi-do (KR)
(74) Representative: Taor, Simon Edward William

(57) **Abstract**

A solar cell includes an optical absorption layer; a buffer layer on the optical absorption layer, the buffer layer having a band gap energy gradient; and a transparent electrode layer on the buffer layer, wherein a band gap energy of a lower surface of the buffer layer is higher than a band gap energy of an upper surface of the buffer layer.

## Description

The present invention relates to solar cells and methods of manufacturing the same.

Recently, as existing fossil energy sources such as petroleum or coal are forecast to become depleted, energy sources that can replace the existing energy sources have drawn attention. Amongst these energy sources, a solar cell that directly transforms solar energy into electrical energy by using a semiconductor device has drawn attention as a next generation energy source.

Embodiments are directed to a solar cell including an optical absorption layer, a buffer layer on the optical absorption layer, the buffer layer having a band gap energy gradient, and a transparent electrode layer on the buffer layer, wherein a band gap energy of a lower surface of the buffer layer is higher than a band gap energy of an upper surface of the buffer layer.

The band gap energy gradient may be continuous or discontinuous.

The buffer layer may include hydrogen. The lower surface of the buffer layer may have a hydrogen concentration higher than the upper surface thereof.

The buffer layer may include phosphorus, wherein the lower surface of the buffer layer has a hydrogen concentration lower than the upper surface thereof.

A band gap energy difference between the lower surface and the upper surface of the buffer layer (ΔEg = E1 - E2, where E1 is the band gap energy of the lower surface and E2 is the band gap energy of the upper surface) may be 0 < ΔEg ≤ 0.6eV.

The buffer layer may be an amorphous phase or a micro crystalline phase.

The solar cell may further include an intrinsic semiconductor layer between the buffer layer and the transparent electrode layer.

The optical absorption layer may include a crystal structure selected from the group of a Cu(In,Ga)Se2 (CIGS) crystal structure, a Cu(In)Se2 (CIS group) crystal structure, a Cu(Ga)Se2 (CGS group) crystal structure, and a Cu(In,Ga)(S,Se)2 (CIGSS group) crystal structure.

Embodiments are also directed to a solar cell including an optical absorption layer, a buffer layer that includes a first buffer layer and a second buffer layer sequentially formed on the optical absorption layer, and a transparent electrode layer on the buffer layer, wherein a band gap energy of the first buffer layer is higher than a band gap energy of the second buffer layer.

The buffer layer may include hydrogen, wherein a hydrogen concentration of the first buffer layer is higher than that of the second buffer layer.

The buffer layer may include phosphorus, wherein a phosphorus concentration of the first buffer layer is lower than that of the second buffer layer.

A band gap energy difference between the first buffer layer and the second buffer layer (ΔEg = E1 - E2, where E1 is the band gap energy of the lower surface and E2 is the band gap energy of the upper surface) may be in a range of 0 < ΔEg ≤ 0.6eV.

The buffer layer may be an amorphous phase, a micro crystalline phase, or a combination of these phases.

The solar cell may further include an intrinsic semiconductor layer between the buffer layer and the transparent electrode layer, wherein the buffer layer is a P-type semiconductor layer and the transparent electrode layer is an N-type semiconductor layer.

Embodiments are also directed to a method of manufacturing a solar cell, the method including: forming a buffer layer having a band gap energy gradient on an optical absorption layer, and forming a transparent electrode layer on the buffer layer, wherein a band gap energy of a lower surface of the buffer layer is higher a band gap energy of an upper surface thereof.

The buffer layer may be formed by using a chemical vapor deposition (CVD) process.

The forming of the buffer layer may include controlling a flow rate of hydrogen included in the buffer layer such that the hydrogen concentration of the lower surface of the buffer layer is higher than that of the upper surface thereof.

The forming of the buffer layer may include controlling a doping concentration of phosphorus included in the buffer layer such that a phosphorus concentration of the lower surface of the buffer layer is lower than that of the upper surface thereof.

The buffer layer may be formed such that a band gap energy difference between the first buffer layer and the second buffer layer (ΔEg = E1 - E2, where E1 is the band gap energy of the lower surface and E2 is the band gap energy of the upper surface) is in a range of 0 < ΔEg ≤ 0.6eV.

The method may further include forming an intrinsic semiconductor layer on the buffer layer between the forming of the buffer layer and the forming of the transparent electrode layer.

According to another aspect of the invention, there is provided a solar cell, comprising: an optical absorption layer; a buffer layer that includes a first buffer layer and a second buffer layer sequentially formed on the optical absorption layer; and a transparent electrode layer on the buffer layer, wherein a band gap energy of the first buffer layer is higher than a band gap energy of the second buffer layer.

In some embodiments, the buffer layer includes hydrogen, wherein a hydrogen concentration of the first buffer layer is higher than that of the second buffer layer.

In some embodiments, the buffer layer includes phosphorus, wherein a phosphorus concentration of the first buffer layer is lower than that of the second buffer layer.

In some embodiments, a band gap energy difference ΔEg between the first buffer layer and the second buffer layer (ΔEg = E1 - E2, where E1 is the band gap energy of the first buffer layer and E2 is the band gap energy of the second buffer layer) is in a range of 0 < ΔEg ≤ 0.6eV.

In some embodiments, the buffer layer is an amorphous phase, a micro crystalline phase, or a combination of these phases.

In some embodiments, the solar cell further comprises an intrinsic semiconductor layer between the buffer layer and the transparent electrode layer, wherein the buffer layer is a P-type semiconductor layer and the transparent electrode layer is an N-type semiconductor layer.

According to another aspect of the invention, there is provided a solar cell as set out in claim 1. Preferred features of this aspect are set out in claims 2 to 12.

According to another aspect of the invention, there is provided a method of manufacturing a solar cell as set out in claim 13. Preferred features of this aspect are set out in claims 14 and 15.

Features will become apparent to those of skill in the art by describing in detail exemplary embodiments with reference to the attached drawings in which:
FIG. 1 illustrates a schematic cross-sectional view of a solar cell according to an embodiment;
FIGS. 2 through 5 illustrate schematic cross-sectional views of a structure of a buffer layer according to embodiments;
FIG. 6 illustrates a diagram showing a band gap energy distribution of a buffer layer according to an embodiment; and
FIGS. 7 through 9 are schematic cross-sectional views illustrating a method of manufacturing a solar cell according to embodiments.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer is referred to as being "between" two layers, it can be the only layer between the two layers, or one or more intervening layers may also be present. Like reference numerals refer to like elements throughout.

The terminologies used herein are for the purpose of describing particular embodiments only and are not intended to be limiting. In the specification, the singular forms include the plural forms unless the context clearly indicates otherwise. It will be understood that the terms "comprise" and/or "comprising" when used in this specification specify the presence of stated features, steps, operations, and/or elements, but do not preclude the presence or addition of one or more other features, steps, operations, and/or elements. It will be understood that, although the terms first, second, etc., may be used herein to describe various elements, these elements should not be limited by these terms. These terms are only used to distinguish one element from another. For convenience of understanding, like reference numerals are used to like elements throughout the specification.

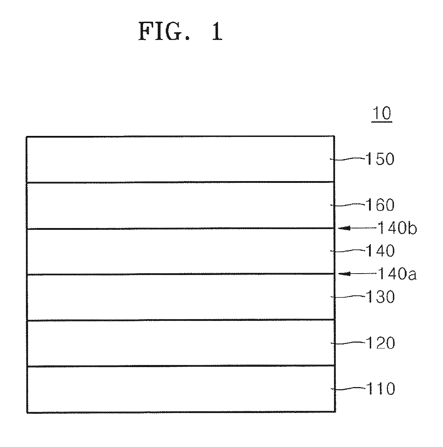

FIG. 1 is a schematic cross-sectional view of a solar cell 10 according to an embodiment.

Referring to FIG. 1, the solar cell 10 may be a rear electrode type solar cell, and may include a buffer layer 140 in which a band gap energy has a gradient. The band gap energy gradient may be continuous or discontinuous.

The solar cell 10 may include a substrate 110, a rear electrode layer 120 formed on the substrate 110, an optical absorption layer 130 formed on the rear electrode layer 120, the buffer layer 140 formed on the optical absorption layer 130, and a transparent electrode layer 150 formed on the buffer layer 140.

An intrinsic semiconductor layer 160 that is not doped with a dopant may further be included between the buffer layer 140 and the transparent electrode layer 150.

The substrate 110 used in the solar cell 10 may be formed of glass or a polymer having a high optical transparency. For example, the glass substrate may be formed of a soda lime glass or a high strained point soda glass, and a polymer substrate may be formed of polyimide. In other implementations, the substrate 110 may be formed of other suitable materials. The glass substrate may be formed of reinforced glass having low iron content to protect internal devices from external impact and to increase transmittance of solar light. In particular, low iron content soda lime glass may further increase the efficiency of the optical absorption layer 130. Na ions in the glass may be eluted at a process temperature of 500°C or above. In other implementations, the substrate 110 may be formed of alumina, ceramic, stainless steel, or a flexible polymer. The rear electrode layer 120 may be formed of a conductive metal having a high optical reflectance, such as molybdenum, aluminum, or copper, to collect charges formed by a photoelectric effect and to reflect light transmitted through the optical absorption layer 130 so that the light is re-absorbed to the optical absorption layer 130.

For example, the rear electrode layer 120 may be formed by including molybdenum, in consideration of a high electrical conductivity, an ohmic contact with the optical absorption layer 130, and a high temperature stability under a selenium or sulfur atmosphere that may be present when the optical absorption layer 130 is formed. The rear electrode layer 120 may have a thickness in a range from about 200 nm to about 500 nm.

The rear electrode layer 120 may be doped with alkali ions such as Na. For example, when the optical absorption layer 130 is grown, the alkali ions that are doped in the rear electrode layer 120 may be mixed in the optical absorption layer 130, and thus, may positively affect the structure of the optical absorption layer 130 and may increase the conductivity of the optical absorption layer 130. Accordingly, an open circuit voltage Voc of the solar cell 10 may be increased, and as a result, the efficiency of the solar cell 10 may be increased.

The rear electrode layer 120 may be formed as a multi-layer film to increase bonding with the substrate 110 and to provide a self-resistance characteristic of the rear electrode layer 120.

The optical absorption layer 130 may form electron-hole pairs by absorbing light, and may provide a current flow by transmitting the electrons and holes to different electrodes.

The optical absorption layer 130 may have a Cu(In,Ga)Se2 (CIGS group) crystal structure, a Cu(In)Se2 (CIS group) crystal structure, a Cu(Ga)Se2 (CGS group) crystal structure, or a Cu(In,Ga)(S,Se)2 (CIGSS group) crystal structure, and may form a P-type semiconductor layer.

The buffer layer 140 according to the current embodiment may include a first interface 140a that contacts the optical absorption layer 130 and a second interface 140b that contacts the transparent electrode layer 150. Herein, a surface of the buffer layer 140 contacting the optical absorption layer 130 at the first interface 140a may be referred to as a "lower surface" and a surface of the buffer layer 140 contacting the transparent electrode layer at the second interface 140b may be referred to as an "upper surface."

In some embodiments (e.g. where there are intervening layers), the "lower surface" is a surface facing the optical absorption layer 130, and the "upper surface" is a surface facing the transparent electrode layer 150.

The buffer layer 140 may have a band gap energy Eg having a gradient in a direction from the first interface 140a to the second interface 140b. The band gap energy Eg may have a gradient that is gradually reduced from the first interface 140a towards the second interface 140b. In other implementations, the band gap energy gradient may be formed as steps. For example, the steps can be provided in some embodiments by providing the buffer layer as two or more distinct layers, each with different band gap energies.

The buffer layer 140 may be formed by using a sputtering process or a chemical vapor deposition (CVD) process. The CVD process may include a plasma CVD (PECVD) process or a low pressure CVD (LPCVD) process. In other implementations, other suitable processes may be used. The buffer layer 140 may be formed to have band gap energies that are different from each other in the direction from the first interface 140a towards the second interface 140b by controlling a dopant or a doping level.

For example, the buffer layer 140 may be an intrinsic semiconductor film having a hydrogen concentration gradient, and the intrinsic semiconductor film may include silicon. For example, the intrinsic semiconductor film may be an amorphous phase, a micro crystalline phase, or a combination of these phases. The intrinsic semiconductor film may be formed to have a band gap energy gradient by controlling the concentration of hydrogen in a process of forming the buffer layer 140.

A higher hydrogen concentration in the buffer layer 140 may correlate with an increased band gap energy Eg of the buffer layer 140, and a lower hydrogen concentration may correlate with a lower band gap energy Eg of the buffer layer 140.

Accordingly, the gradient of the band gap energy Eg of the buffer layer 140 may be formed by controlling the hydrogen concentration so that the first interface 140a of the buffer layer 140 has a high hydrogen concentration and the second interface 140b of the buffer layer 140 has a low hydrogen concentration.

In other implementations, the buffer layer 140 may be a semiconductor film having a phosphorus concentration gradient, and the semiconductor film may include silicon Si. For example, the semiconductor film may be an amorphous phase, a micro crystalline phase, or a combination of these phases. The semiconductor film may be formed to have a band gap energy gradient by controlling the concentration of phosphorus in a process of forming the buffer layer 140.

A higher phosphorus concentration included in the buffer layer 140 may correlate with a decreased band gap energy Eg of the buffer layer 140, and a lower phosphorus concentration may correlate with an increased band gap energy Eg of the buffer layer 140.

Accordingly, the gradient of the band gap energy Eg of the buffer layer 140 may be formed by controlling the phosphorus concentration so that the first interface 140a of the buffer layer 140 has a low phosphorus concentration and the second interface 140b of the buffer layer 140 has a high phosphorus concentration.

The buffer layer 140 may have a band gap energy gradient. Accordingly, the efficiency of the solar cell 10 is increased.

The transparent electrode layer 150 may form a P-N junction with the optical absorption layer 130. The transparent electrode layer 150 may be formed of a material having a high optical transmittance so that solar light is transmitted to the optical absorption layer 130. Also, the transparent electrode layer 150 may be formed of a conductive material having a low resistance to be able to function as an electrode layer.

As examples, the transparent electrode layer 150 may be formed of zinc oxide ZnO doped with boron B or aluminum Al or indium tin oxide (ITO). The zinc oxide ZnO doped with boron B or aluminum Al has a low resistance, and thus, may be suitable to be used as an electrode. In particular, zinc oxide ZnO doped with boron B may increase transmittance of light of near infrared rays, and thus, may increase a short circuit current of the solar cell 10.

Also, a p-i-n diode type solar cell may be formed by further including the undoped intrinsic semiconductor layer 160 between the buffer layer 140 and the transparent electrode layer 150.

The intrinsic semiconductor layer 160 may be formed of undoped zinc oxide ZnO, as an example.

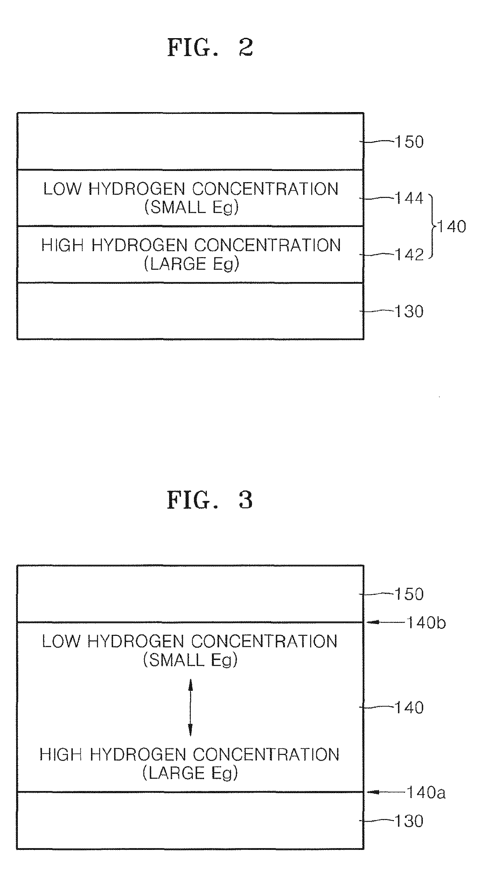

FIGS. 2 through 5 are schematic cross-sectional views of structures of the buffer layer 140 according to embodiments.

FIG. 2 is a cross-sectional view illustrating the buffer layer 140 having first and second buffer layers 142 and 144 that have hydrogen concentrations different from each other.

Referring to FIG. 2, the buffer layer 140 may include the first buffer layer 142 and the second buffer layer 144. The first and second buffer layers 142 and 144 may have stepwise band gap energies different from each other.

For this purpose, the first and second buffer layers 142 and 144 may have hydrogen concentrations different from each other. According to the hydrogen concentration, the first buffer layer 142 may have band gap energy higher than that of the second buffer layer 144.

In FIG. 2, the buffer layer 140 has two layers of the first and second buffer layers 142 and 144. In other implementations, the buffer layer 140 may include at least two layers having band gap energies different from each other, and each of the layers may have a gradually reduced band gap energy in a direction from the optical absorption layer 130 towards the transparent electrode layer 150.

FIG. 3 is a cross-sectional view illustrating the buffer layer 140 in which the gradient of band gap energies Eg are formed by varying hydrogen concentrations according to heights.

Referring to FIG. 3, unlike the buffer layer 140 of FIG. 2, the buffer layer 140 having a single layer is depicted. The buffer layer 140 may have a hydrogen concentration gradient that is gradually reduced from the first interface 140a that contacts the optical absorption layer 130 to the second interface 140b that contacts the transparent electrode layer 150.

Accordingly, the buffer layer 140 may form a band gap energy gradient gradually reducing from the first interface 140a to the second interface 140b.

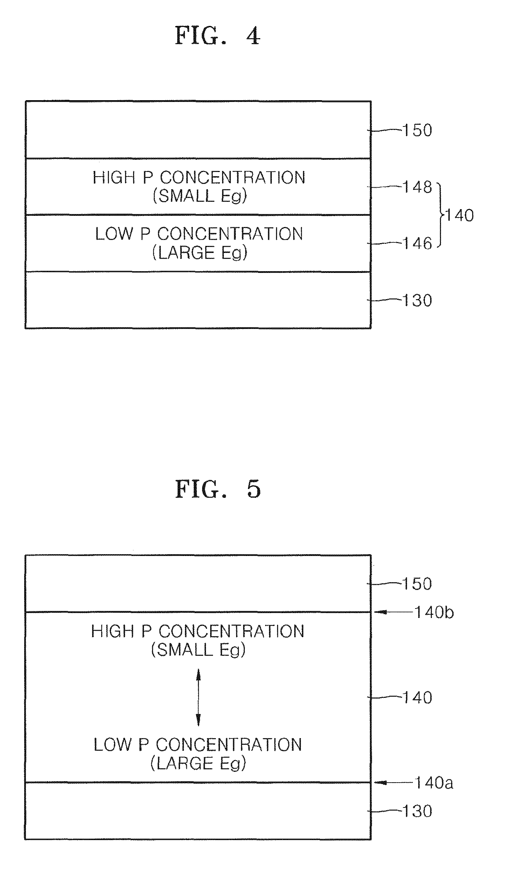

FIG. 4 is a cross-sectional view illustrating a buffer layer 140 having first and second buffer layers 146 and 148 that have phosphorus concentrations different from each other.

Referring to FIG. 4, the buffer layer 140 may include the first and second buffer layers 146 and 148. The first and second buffer layers 146 and 148 may have stepwise band gap energies Eg different from each other.

For this purpose, the first and second buffer layers 146 and 148 may have phosphorus concentrations that are different from each other. The first buffer layer 146 may have band gap energy Eg higher than that of the second buffer layer 148 according to the phosphorus concentrations.

In FIG. 4, the buffer layer 140 having two layers of the first and second buffer layers 146 and 148 is depicted. In other implementations, the buffer layer 140 may include at least two layers having band gap energies Eg different from each other, and each of the layers may have band gap energy Eg gradually reducing in a direction from an interface of the optical absorption layer 130 towards an interface of the transparent electrode layer 150.

FIG. 5 is a cross-sectional view illustrating the buffer layer 140 in which the gradient of band gap energies Eg are formed by varying phosphorus concentrations according to heights.

Referring to FIG. 5, unlike the buffer layer 140 of FIG. 4, a buffer layer 140 having a single layer is depicted. The buffer layer 140 may have a phosphorus concentration gradient that gradually increases from the first interface 140a that contacts the optical absorption layer 130 to the second interface 140b that contacts the transparent electrode layer 150.

Accordingly, the buffer layer 140 may form a band gap energy gradient gradually reducing from the first interface 140a to the second interface 140b.

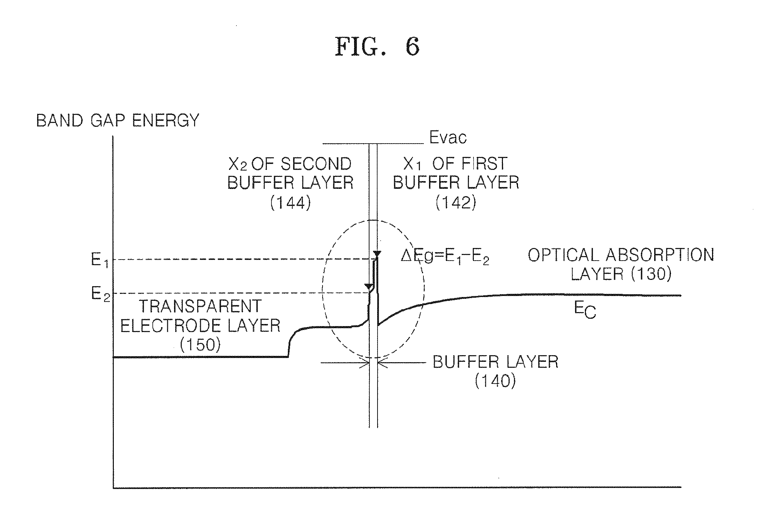

FIG. 6 is a diagram showing a band gap energy distribution of a buffer layer according to an embodiment. The band gap energy Eg of the buffer layer 140 may be ensured, for example by using Technology Computer-Aided Design (TCAD) systems provided by Synopsys Company.

Referring to FIGS. 2 and 6, Ec indicates a conduction band energy band, and Evac indicates an energy level at a vacuum region.

In the buffer layer 140, the first buffer layer 142 that contacts the optical absorption layer 130 has a band gap energy Eg that is different from that of the second buffer layer 144 that contacts the transparent electrode layer 150. The band gap energy Eg of the first buffer layer 142 may be higher than that of the second buffer layer 144.

The band gap energies Eg of the first and second buffer layers 142 and 144 may be expressed as electron affinities X1 and X2. The electron affinity may be defined as X (electron affinity)=Evac (vacuum level) - Ec( conduction band energy).

The smaller the band gap energy Eg of the second buffer layer 144 when compared to the band gap energy of the first buffer layer 142, that is, the higher the X2, the more a width of an energy barrier from the optical absorption layer 130 to the buffer layer 140 is reduced.

Accordingly, electrons generated from the optical absorption layer 130 may be easily tunneled to the buffer layer 140, and as a result, the efficiency of the solar cell 10 may be increased.

The buffer layer 140 may be formed to have a band gap energy difference ΔEg between the highest band gap energy E1 and the lowest band gap energy E2, (that is, ΔEg, E1-E2), in a range of 0 < ΔEg ≤ 0.6eV.

Table 1 shows short circuits Jsc(mA/cm2) according to values of band gap energies of the first and second buffer layers 142 and 144, open circuit voltage Voc (V), fill factor (%), and efficiency of the solar cell 10 Eff (%) in the buffer layer 140 illustrated in FIG. 2.

**[Table 1]**

| Thickness of first buffer layer (nm) | Thickness of second buffer layer (nm) | Arrangements | Electron affinity of first buffer layer (X1) | Electron affinity of second buffer layer (X2) | Jsc (mA/cm²) | Voc (V) | FF (%) | Eff (%) |
|---|---|---|---|---|---|---|---|---|
| 2.5nm | 2.5nm | 1 | 4.3 | 4 | 34.788 | 0.627 | 53.542 | 11.678 |
| | | 2 | 4.3 | 4.3 | 34.745 | 0.658 | 73.238 | 16.744 |
| | | 3 | 4.3 | 4.4 | 34.77 | 0.658 | 73.245 | 16.758 |
| | | 4 | 4.3 | 4.5 | 34.773 | 0.658 | 73.247 | 16.76 |
| | | 5 | 4.3 | 4.7 | 34.821 | 0.659 | 73.425 | 16.851 |

Referring to Table 1, Arrangement 1 shows a characteristic of a solar cell when the electron affinity X1 of the first buffer layer 142 is higher than the electron affinity X2 of the second buffer layer 144, and Arrangement 2 shows a characteristic of the solar cell when the electron affinities X1 and X2 of the first buffer layer 142 and the second buffer layer 144 are equal (X1=X2).

Arrangements 3 through 5 show characteristics of a solar cell according to the gradient of the band gap energy Eg of the buffer layer 140 according to embodiments of the invention. When compared to Arrangements 1 and 2, it is seen that the fill factor and efficiency of the solar cell of the Arrangements 3 through 5 are higher than those of the Arrangements 1 and 2.

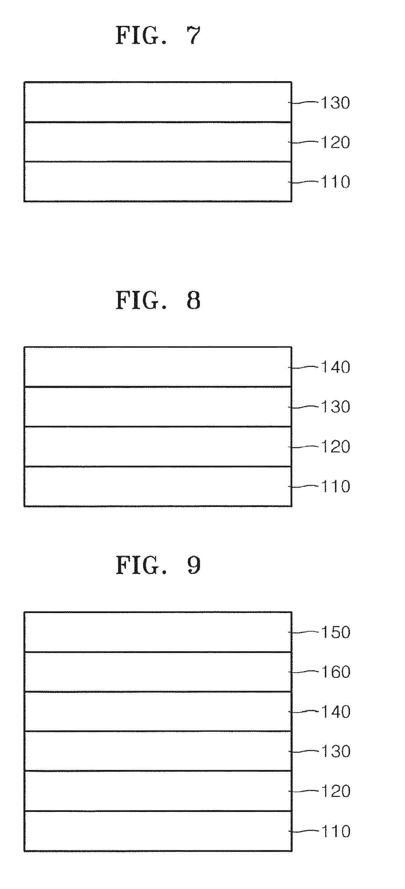

FIGS. 7 through 9 are schematic cross-sectional views illustrating stages of a method of manufacturing a solar cell according to embodiments.

Referring to FIG. 7, a rear electrode layer 120 may be formed on a substrate 110. As described above, the rear electrode layer 120 may be formed of molybdenum Mo, which is a material that generally satisfies functions desirable for the rear electrode layer 120. The rear electrode layer 120 may be formed by a DC sputtering method using molybdenum Mo as a target. In other implementations, the rear electrode layer 120 may be formed by a chemical vapor deposition (CVD) method.

Next, an optical absorption layer 130 and, referring to FIG. 8, a buffer layer 140 having a band gap energy gradient may be formed on the rear electrode layer 120.

The buffer layer 140 may be formed by using a sputtering process or a CVD process, and a dopant and a doping level of the buffer layer 140 may be controlled to have a band gap energy gradient.

The buffer layer 140 may be an intrinsic semiconductor film having a hydrogen concentration gradient, and the intrinsic semiconductor film may be an amorphous phase, a micro crystalline phase, or a combination of these phases. The buffer layer 140 may be formed to have a band gap energy gradient by controlling hydrogen content in the buffer layer 140 in a process of forming the buffer layer 140.

In other implementations, the buffer layer 140 may be a semiconductor film having a phosphorus concentration gradient, and the semiconductor film may be an amorphous phase, a micro crystalline phase, or a combination of these phases. The buffer layer 140 may be formed to have a band gap energy gradient by controlling phosphorus content in the buffer layer 140 in a process of forming the buffer layer 140. The buffer layer 140 may be formed to have a band gap energy difference ΔEg between the highest band gap energy E1 and the lowest band gap energy E2, (that is, ΔEg = E1 - E2) that is in a range of o < ΔEg ≤ 0.6eV.

Referring to FIG. 9, an intrinsic semiconductor layer 160 and a transparent electrode layer 150 may be formed on the buffer layer 140.

The intrinsic semiconductor layer 160 may be formed of undoped zinc oxide ZnO. As an example, the intrinsic semiconductor layer 160 may be deposited by a PECVD process.

The transparent electrode layer 150 may be formed primarily of zinc oxide ZnO, though other embodiments could use other materials. Accordingly, the transparent electrode layer 150 may be formed by using one of an RF sputtering method that uses zinc oxide as a target, a reactive sputtering method that uses Zn as a target, and a metal organic chemical vapor deposition (MOCVD) method.

Next, a reflection prevention film may be formed on the transparent electrode layer 150. The reflection prevention film may be formed by an electron beam evaporation method using MgF₂.

In the method of the solar cell according to the present embodiment, the buffer layer 140 having a band gap energy gradient that gradually decreases from the optical absorption layer 130 towards the transparent electrode layer 150 may be formed. The band gap energy gradient of the buffer layer 140 may be formed by controlling the concentration of a material, such as hydrogen or phosphorus included in the buffer layer 140. Accordingly, the process of manufacturing a solar cell may be simplified.

Electrons generated from the optical absorption layer 130 may readily pass through the buffer layer 140. Accordingly, the efficiency of the solar cell may be increased.

By way of summation and review, the cost of power generation of a commercial solar cell is currently higher than the cost of thermal power. It is desirable to increase the power generation efficiency of the solar cell in order to apply the solar cell to various fields. In order to increase power generation efficiency, it may be desirable to reduce an optical loss and a recombination loss, and to reduce a series resistance of an optical current that is generated from a solar cell. Also, for mass production of high efficiency solar cells, it may be desirable to develop a new solar cell structure based on low manufacturing costs and process simplification.

One or more embodiments include solar cells having a high efficiency and a simplified manufacturing process and methods of manufacturing the same. According to an embodiment, efficiency of a solar cell may be increased through a band gap energy gradient of a buffer layer.

As discussed, embodiments of the invention provide a solar cell, comprising: an optical absorption layer; a buffer layer over the optical absorption layer, the buffer layer having a band gap energy gradient; and a transparent electrode layer over the buffer layer, wherein the band gap energy gradient of the buffer layer is such that a band gap energy of the buffer layer decreases in a direction from the optical absorption layer to the transparent electrode.

In some embodiments, the buffer layer may be formed from a semiconductor including silicon. In some embodiments, the buffer layer may be one or more layers of silicon doped (e.g. with P) to have a band gap gradient.

The band gap energy gradient may be continuous or discontinuous, and the band gap energy gradient may be provided by a single layer buffer layer or a multilayer buffer layer.

In some embodiments, a band gap energy of a lower surface of the buffer layer is higher than a band gap energy of an upper surface thereof. The lower surface of the buffer layer is a surface facing the optical absorption layer, and the upper surface is a surface facing the transparent electrode layer.

The buffer layer has a portion proximate the optical absorption layer and a portion proximate the transparent electrode, wherein a band gap energy of a portion of the buffer layer proximate the optical absorption layer is higher than a band gap energy of a portion proximate the transparent electrode.

In some embodiments, the buffer layer includes a first buffer layer and a second buffer layer sequentially formed on the optical absorption layer, wherein a band gap energy of the first buffer layer is higher than a band gap energy of the second buffer layer.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope thereof as set forth in the following claims.

## Claims

1. A solar cell, comprising:
an optical absorption layer;
a buffer layer over the optical absorption layer, the buffer layer having a band gap energy gradient; and
a transparent electrode layer over the buffer layer,
wherein the band gap energy gradient of the buffer layer is such that a band gap energy of the buffer layer decreases in a direction from the optical absorption layer to the transparent electrode.

2. The solar cell as claimed in claim 1, wherein the band gap energy gradient is continuous or discontinuous.

3. The solar cell as claimed in claim 1 or 2, wherein the buffer layer includes hydrogen, a lower surface of the buffer layer having a hydrogen concentration higher than an upper surface thereof.

4. The solar cell as claimed in any one of claims 1 to 3, wherein the buffer layer includes phosphorus, a lower surface of the buffer layer having a phosphorus concentration lower than an upper surface thereof.

5. The solar cell as claimed in claim 1, wherein a band gap energy difference ΔEg between a lower surface and an upper surface of the buffer layer is in a range of 0 < ΔEg ≤ 0.6eV, where:
ΔEg = E1 - E2, where E1 is the band gap energy of the lower surface and E2 is the band gap energy of the upper surface.

6. The solar cell as claimed in any one of claims 1 to 5, wherein the buffer layer includes a first buffer layer and a second buffer layer sequentially formed on the optical absorption layer, wherein a band gap energy of the first buffer layer is higher than a band gap energy of the second buffer layer.

7. The solar cell as claimed in claim 6, wherein the buffer layer includes hydrogen, wherein a hydrogen concentration of the first buffer layer is higher than that of the second buffer layer.

8. The solar cell as claimed in claim 6 or 7, wherein the buffer layer includes phosphorus, wherein a phosphorus concentration of the first buffer layer is lower than that of the second buffer layer.

9. The solar cell as claimed in any one of claims 6 to 8, wherein a band gap energy difference ΔEg between the first buffer layer and the second buffer layer is in a range of o < ΔEg ≤ 0.6eV, where:
ΔEg = E1 - E2, where E1 is the band gap energy of the first buffer layer and E2 is the band gap energy of the second buffer layer.

10. The solar cell as claimed in any one of claims 1 to 9, wherein the buffer layer comprises an amorphous phase, a micro crystalline phase, or a combination of these phases.

11. The solar cell as claimed in any one of claims 1 to 10, further comprising an intrinsic semiconductor layer between the buffer layer and the transparent electrode layer, optionally wherein the buffer layer is a P-type semiconductor layer and the transparent electrode layer is an N-type semiconductor layer.

12. The solar cell as claimed in any one of claims 1 to 11, wherein the optical absorption layer includes a crystal structure selected from the group of a Cu(In,Ga)Se2 (CIGS) crystal structure, a Cu(In)Se2 (CIS group) crystal structure, a Cu(Ga)Se2 (CGS group) crystal structure, and a Cu(In,Ga)(S,Se)2 (CIGSS group) crystal structure.

13. A method of manufacturing a solar cell, the method comprising:
forming a buffer layer having a band gap energy gradient over an optical absorption layer; and
forming a transparent electrode layer over the buffer layer,
wherein the band gap energy gradient of the buffer layer is such that a band gap energy of the buffer layer decreases in a direction from the optical absorption layer to the transparent electrode.

14. The method as claimed in claim 13, wherein the buffer layer is formed by using a chemical vapor deposition (CVD) process.

15. The method as claimed in claim 13 or 14, wherein the forming of the buffer layer includes controlling a flow rate of hydrogen included in the buffer layer such that hydrogen concentration of the lower surface of the buffer layer is higher than that of the upper surface thereof; and/or
wherein the forming of the buffer layer includes controlling a doping concentration of phosphorus included in the buffer layer such that a phosphorus concentration of the lower surface of the buffer layer is lower than that of the upper surface thereof.
